# Europäisches Patentamt
## European Patent Office
## Office européen des brevets

(19)

(11) Veröffentlichungsnummer: **0 107 061**
**B1**

(12)

# EUROPÄISCHE PATENTSCHRIFT

(45) Veröffentlichungstag der Patentschrift:
**31.05.89**

(51) Int. Cl.⁴: **G 06 K 19/06**

(21) Anmeldenummer: **83109536.9**

(22) Anmeldetag: **24.09.83**

(54) Informationskarte und Verfahren zu ihrer Herstellung.

(30) Priorität: **27.09.82 DE 3235650**

(43) Veröffentlichungstag der Anmeldung:
**02.05.84 Patentblatt 84/18**

(45) Bekanntmachung des Hinweises auf die Patenterteilung:
**31.05.89 Patentblatt 89/22**

(84) Benannte Vertragsstaaten:
**CH DE FR GB IT LI**

(56) Entgegenhaltungen:
**DE-A-3 029 667**
**DE-A-3 047 322**
**DE-A-3 130 213**

(73) Patentinhaber: **Philips Patentverwaltung GmbH, Wendenstrasse 35 Postfach 10 51 49, D-2000 Hamburg 1 (DE)**
(84) Benannte Vertragsstaaten: **DE**

(73) Patentinhaber: **N.V. Philips' Gloeilampenfabrieken, Groenewoudseweg 1, NL- 5621 BA Eindhoven (NL)**
(84) Benannte Vertragsstaaten: **CH FR GB IT LI**

(72) Erfinder: **Uden, Edward, Gebrüder- Strasse 38, D-2202 Barmstedt (DE)**

(74) Vertreter: **David, Günther M., Philips Patentverwaltung GmbH Wendenstrasse 35 Postfach 10 51 49, D-2000 Hamburg 1 (DE)**

LIBER STOCKHOLM 1989

## Beschreibung

Die Erfindung betrifft eine Informationskarte mit einem zwischen einer unteren Deckfolie und einer oberen Deckfolie liegenden Kartenkörper, bei der an der Stelle eines Teiles des Kartenkörpers mindestens ein Trägerkörper für mindestens ein Halbleiterbauelement vorhanden ist, bei der jedes Halbleiterbauelement durch einen Halbleiterchip gebildet wird, der in einer Aussparung einer das Trägerelement bildenden Folie liegt, mit Leiterbahnen auf dieser Folie elektrisch verbunden ist und mit einem Harz mit der Folie zu einer kompakten Einheit vorgegebener Dicke vergossen ist.

Ein Trägerkörper für mindestens ein Halbleiterbauelement für eine Informationskarte der genannten Art ist bekannt aus der DE-OS-3 029 667.

Bei diesem bekannten Trägerkörper ist der Halbleiterchip in einer relativ großen Aussparung einer Folie angeordnet und durch Drahtverbindungen mit Leiterbahnen verbunden, die auf die Unterseite der Folie aufgebracht sind und sich bis unter die Aussparung erstrecken. Die Kontaktierung eines so angeordneten Halbleiterchips mit Drahtverbindungen ist jedoch außerordentlich schwierig und zudem muß die Folie eine Dicke haben, die wesentlich größer ist als die Dicke des Halbleiterchips, da die mit dem Halbleiterchip verbundenen Kontaktierungsdrähte nicht über die Aussparung in der Folie hinausragen dürfen. Zudem ist es erforderlich, den Halbleiterchip beim Einsetzen in die Ausnehmung auszurichten, was einen besonderen Arbeitsschritt erforderlich macht.

Insbesondere hat sich aber gezeigt, daß bei mit dem bekannten Trägerkörper versehenen Informationskarten durch die bei ihrer Benutzung unvermeidlichen Biegebeanspruchungen an dem Halbleiterchip unzulässig hohe Biegekräfte auftreten können.

Der Erfindung liegt daher die Aufgabe zugrunde, eine Informationskarte der eingangs genannten Art so auszugestalten, daß die von dem Halbleiterchip Biegekräfte weitgehend ferngehalten werden und weiter Verbindungen zwischen dem oder den Halbleiterchips in der Karte und den zugehörigen Leiterbahnen auf einfache Weise in Drahtverbindungstechnik ausgeführt werden können und die Dicke der Karte trotzdem das genormte Maß von etwa 0,76 mm nicht überschreitet.

Diese Aufgabe wird erfindungsgemäß dadurch gelöst, daß für jeden Halbleiterchip

a)  die den Trägerkörper bildende Folie auf der mit den Drahtverbindungen verbundenen Seite eine den Halbleiterchip und die Verbindungspunkte umgebenden ringförmigen Begrenzungskörper von solcher Hohe trägt, daß der Abstand von der Unterseite des Trägerkörpers bis zum oberen Rand des Begrenzungskörpers praktisch gleich der Dicke des Kartenkörpers ist und die so gebildete Einheit in eine Ausnehmung des Kartenkörpers eingesetzt ist,
b)  der Raum innerhalb des Begrenzungskörpers bis zu der durch seinen oberen Rand begrenzten Fläche mit einer den Halbleiterchip und die Verbindungsdrähte umhüllenden Abdeckmasse ausgefüllt ist.

Eine so ausgebildete Informationskarte hat den Vorteil, daß sie unter Anwendung erprobter Verbindungstechniken hergestellt werden kann, starken Beanspruchungen, insbesondere Biegebeanspruchungen widersteht, ohne daß an den Halbleiterchips unzulässig große Biegebeanspruchungen auftreten oder gar die Verbindungen zwischen Halbleiterchips und Leiterbahnen zerstört werden und die genormte Dicke nicht überschreitet.

Weitere Ausgestaltungen der Erfindung ergeben sich aus den Unteransprüchen.

Vorzugsweise ist der durch die Ausstanzung gebildete Teil der unteren Fläche des Trägerkörpers mit einer den Halbleiterchip tragenden Folie bedeckt.

Der Begrenzungskörper besteht vorzugsweise aus Glasepoxyd oder PVC und ist mit einer Abdeckmasse aus Epoxydharz oder Silikonkautschuk gefüllt.

Ein zweckmäßiges Verfahren zur Herstellung einer Informationskarte nach der Erfindung, dadurch gekennzeichnet, daß der Trägerkörper an seiner Unterseite zunächst mit einer Folie bedeckt wird, dann in der Ausstanzung des Trägerkörpers der Halbleiterchip auf die Folie aufgeklebt wird, die Drahtverbindungen zwischen dem Halbleiterchip und den Leiterbahnen auf dem Trägerkörper hergestellt, der Begrenzupgskörper angebracht und der Rauminhalt dieses Begrenzungskörpers mit einer Abdeckmasse ausgefüllt wird, und dann, vor dem Fertigstellen der Karte die Folie von der unteren Fläche des Trägerkörpers wieder entfernt wird. Vorzugsweise ist die Folie selbstklebend.

Ein Ausführungsbeispiel der Erfindung wird im folgenden anhand der beigefügten Zeichnung näher erläutert.

Es zeigen:

Figur 1 einen Querschnitt durch eine Informationskarte und

Figur 2 ein Detail des Querschnitts nach Figur 1.

Die Figuren sind nicht maßgeblich, sondern nur schematisch und in den Vertikalabmessungen stark überhöht.

Die Informationskarte kann mehrere Halbleiterchips enthalten. Für jeden dieser Chips ist dann eine gesonderte Ausstanzung in dem Trägerkörper vorgesehen und jeder Chip und seine Drahtverbindungen sind von einem gesonderten Begrenzungskörper umgeben und in Abdeckmasse eingehüllt.

Der Übersichtlichkeit halber ist in den Figuren also nur ein Halbleiterchip 5 dargestellt

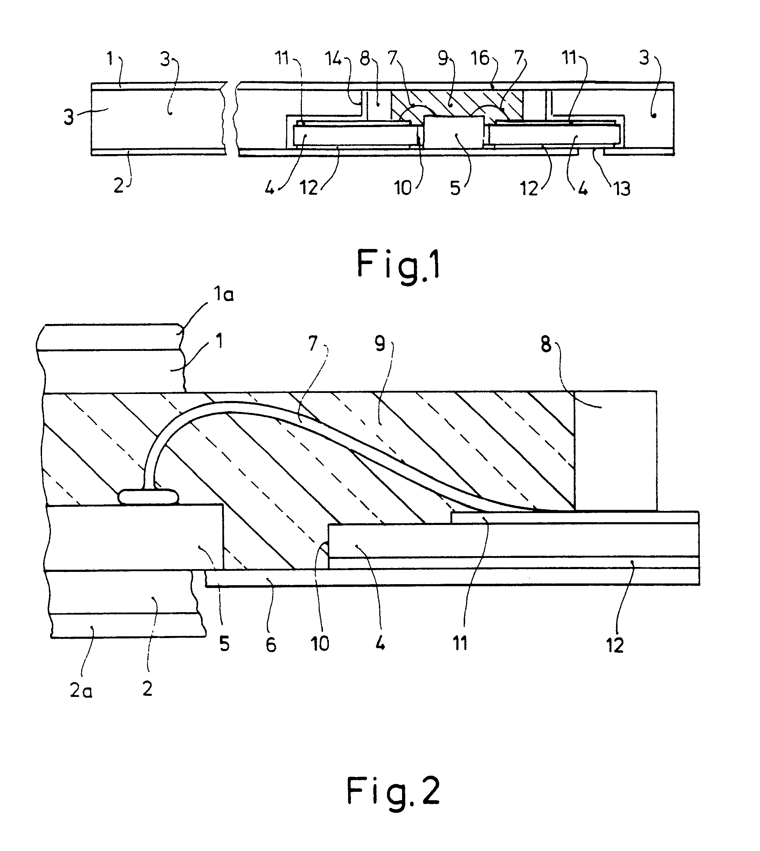

Die Figur 1 zeigt einen Querschnitt durch eine Informationskarte nach der Erfindung, die in der Hauptsache aus einem Kartenkörper 3 besteht, der von einer oberen Deckfolie 1 und einer unteren Deckfolie 2 bedeckt ist.

Der Kartenkörper 3 weist dabei eine Ausnehmung 14 für einen Trägerkörper 4 auf. Der Trägerkörper 4 ist mit einer Ausstanzung 10 versehen in die ein Halbleiterchip 5 so eingesetzt ist, daß seine untere Fläche mit der unteren Fläche des Trägerkörpers 4 in einer Ebene liegt. Der Trägerkörper 4 trägt sowohl auf seiner Oberseite als auch auf seiner Unterseite Leiterbahnen 11 und 12, die auf geeignete Weise miteinander verbunden sind und die zu Anschlußkontaktflächen 13 führen, welche durch Öffnungen in der unteren Deckfolie 2 der Informationskarte hindurch zugänglich sind um eine Kontaktierung der in der Karte enthaltenen Halbleiterchips zu ermöglichen.

Die Kontaktierungsflächen des Halbleiterchips 5 sind durch, z. B. mit Hilfe eines Ultraschallbandverfahrens angebrachten Drahtverbindungen 7 mit den Leiterbahnen 11 auf der Oberseite des Trägerkörpers 4 verbunden. Der Bogen der Verbindungsdrähte 7 verläuft dabei so flach, daß ihr höchster Punkt noch unter der Oberfläche der Abdeckmasse 9 bleibt.

Um dem Halbleiterchip 5 in der Ausstanzung 10 des Trägerkörpers und den Drahtverbindungen 7 einen sicheren Halt zu geben, sind der Halbleiterchip 5 und die Drahtverbindungen 7 auf der Oberseite des Trägerkörpers 4 von einem ringförmigen Begrenzungskörper 8 umgeben, dessen Höhe so gewählt ist, daß die durch seine Höhe und die Dicke der Deckfolien 1 und 2 bestimmte Dicke der gesamten Karte den genannten Wert von etwa 0,76 mm nicht überschreitet. Der innerhalb des ringförmigen Begrenzungskörpers 8 gebildete Raum ist mit einer Abdeckmasse 9 aus Epoxydharz oder Silikonkautschuk ausgefüllt.

Wenn einer der Halbleiterchips 5 ein Speicherbauelement ist, dessen gespeicherte Information durch Bestrahlung mit z. B. UV-Licht gelöscht werden kann, ist die obere Deckfolie 1 mit einem geeigneten Fenster versehen.

Die beiden Deckfolien 1 und 2 können zweiteilig ausgeführt sein, wobei der untere Teil 1 bzw. 2 einen Aufdruck etc. tragen kann, der dann durch den oberen Teil 1a bzw. 2a geschützt ist. Eine so aufgebaute Informationskarte wird vorzugsweise wie folgt hergestellt:

Ein als Trägerkörper 4 dienendes Folienstück aus glasfaserverstärktem Epoxydharz von 0,1 mm Dicke wird zunächst auf beiden Seiten mit Leiterbahnen 11, 12 und Anschlußkontaktflächen 13 aus Gold versehen. Dann wird in diesen Trägerkörper eine Öffnung 10 für den Halbleiterchip 5 eingestanzt. Anschließend wird die Rückseite dieses Trägerkörpers 4 mit einer selbstklebenden Folie 15 beklebt und der Halbleiterchip 5 in der Öffnung 15 im Trägerkörper 4 auf diese selbstklebende Folie 6 aufgeklebt. Dann werden mit einem bei der Herstellung von Halbleiterbauelementen üblicherweise verwendeten Ultraschall-Drahtbonder die Drahtverbindungen 7 zwischen den Anschlußflächen auf den Halbleiterchips 5 und den Leiterbahnen 11 auf der Oberseite des Trägerkörpers 4 hergestellt. Dabei wird darauf geachtet, daß der Bogen der Drahtverbindungen 7 so flach wie möglich verläuft. Anschließend wird ein ebenfalls aus glasfaserverstärktem Epoxydharz ausgestanzter Ring 8 von etwa 0,4 mm Höhe so auf den Trägerkörper 4 aufgeklebt, daß er den Halbleiterchip 5 und die Drahtverbindungen 7 umgibt.

Der von den ringförmigen Begrenzungskörpern umgebene Raum über den Halbleiterchip 5 und den Drahtverbindungen 7 wird dann mit einer Abdeckmasse 9 aus mit $SiO_2$ gefülltem Epoxydharz ausgefüllt und diese Abdeckmasse dann durch eine Wärmebehandlung gehärtet. Anschließend wird die Oberseite des Begrenzungskörpers 8 und der Abdeckmasse 9 soweit abgeschliffen, daß der Abstand zwischen der Unterseite des Trägerkörpers 4 und der Oberseite des Begrenzungskörpers 8 etwa 0,44 mm beträgt.

Schließlich wird die selbstklebende Folie 6, die bisher den Halbleiterchip 5 getragen hat, abgezogen und die Einheit aus Trägerkörper 4 und Halbleiterchip 5 in die Ausnehmung 14 des Kartenkörpers 3 aus PVC (siehe Figur 1) eingesetzt und beides zwischen einer oberen Deckfolie 1 und einer unteren Deckfolie 2, beide ebenfalls aus PVC, unter Druck und erhöhter Temperatur so zusammengepreßt und bei aufrechterhaltenem Druck anschließend abgekühlt, daß die fertige Informationskarte die genormte Dicke von 0,76 mm hat. Die untere Deckfolie 2 ist über den Kontaktflächen 13 an der Unterseite des Trägerkörpers 4 mit Öffnungen versehen.

**Patentansprüche**

1. Informationskarte mit einem zwischen einer unteren Deckfolie (2), und einer oberen Deckfolie (1) liegenden Kartenkörper (3) bei der an der Stelle eines Teiles des Kartenkörpers mindestens ein Trägerkörper (4) für mindestens ein Halbleiterbauelement vorhanden ist, bei der jedes Halbleiterbauelement durch einen Halbleiterchip (5) gebildet wird, der in einer Aussparung einer den Trägerkörper (4) bildenden Folie liegt, mit Leiterbahnen (11) auf dieser Folie elektrisch verbunden ist und mit einem Harz (9) mit der Folie zu einer kompakten Einheit vorgegebener Dicke vergossen ist, und bei der die Aussparung (10) den Halbleiterchip (5) eng umschließt und die Kontaktierungsflächen durch Drahtverbindungen (7) mit Leiterbahnen (11) auf der Trägerfolie (4) verbunden sind,

dadurch gekennzeichnet,

daß für jeden Halbleiterchip (5)

a) die den Trägerkörper (4) bildende Folie auf der mit den Drahtverbindungen (7) verbundenen Seite eine den Halbleiterchip (5) und die Verbindungspunkte umgebenden ringförmigen Begrenzungskörper (8) von solcher Höhe trägt, daß der Abstand von der Unterseite des Trägerkörpers (4) bis zum oberen Rand des Begrenzungskörpers praktisch gleich der Dicke des Kartenkörpers (3) ist und die so gebildete Einheit (4, 5, 8) in eine Ausnehmung (14) des Kartenkörpers (3) eingesetzt ist,

b) der Raum innerhalb des Begrenzungskörpers (8) bis zu der durch seinen oberen Rand begrenzten Fläche mit einer den Halbleiterchip (5) und die Verbindungsdrähte (7) umhüllenden Abdeckmasse (9) ausgefüllt ist.

2. Informationskarte nach Anspruch 1,
dadurch gekennzeichnet,
daß mindestens der durch die Aussparung (10) gebildete Teil der unteren Fläche des Trägerkörpers (4) mit einer den Halbleiterchip (5) tragenden Hilfsfolie (6) bedeckt ist.

3. Informationskarte nach einem der vorangehenden Ansprüche,
dadurch gekennzeichnet,
daß die obere Deckfolie (1) über mindestens einem der Halbleiterchips (5) mit einem strahlungsdurchlässigen Fenster versehen ist.

4. Informationskarte nach einem der vorangehenden Ansprüche,
dadurch gekennzeichnet,
daß der Trägerkörper (4) aus Glasepoxyd oder PVC besteht.

5. Informationskarte nach einem der vorangehenden Ansprüche,
dadurch gekennzeichnet,
daß der Begrenzungskörper (8) aus Glasepoxyd oder PVC besteht.

6. Informationskarte nach einem der vorangehenden Ansprüche,
dadurch gekennzeichnet,
daß die Abdeckmasse (9) aus Epoxydharz oder Siliconkautschuk besteht.

7. Verfahren zur Herstellung einer Informationskarte nach Anspruch 1 oder 2,
dadurch gekennzeichnet,
daß der Trägerkörper (4) an seiner Unterseite zunächst mit einer Folie (6) bedeckt wird, dann in der Aussparung (10) des Trägerkörpers der Halbleiterchip (5) auf die Folie aufgeklebt wird, die Drahtverbindungen (7) zwischen dem Halbleiterchip (5) und den Leiterbahnen (11) auf dem Trägerkörper (4) hergestellt, der Begrenzungskörper (8) angebracht und der Rauminhalt dieses Begrenzungskörpers mit der Abdeckmasse (9) ausgefüllt wird, und dann, vor dem Fertigstellen der Karte die Folie (6) von der unteren Fläche des Trägerkörpers (4) wieder entfernt wird.

8. Verfahren nach Anspruch 7,
dadurch gekennzeichnet,
daß eine selbstklebende Folie verwendet wird.

**Claims**

1. A data card comprising a lower covering foil (2), an upper covering foil (1) and a card body (3) in between said covering foils, in which instead of a portion of the card body at least one carrier member (4) for at least one semiconductor element is present, each semiconductor element being constituted by a semiconductor chip (5) which is located in a recess of a foil constituting the carrier member (4), is electrically connected to conductor tracks (11) on this foil and is moulded using a resin (9) to form one compact unit with the foil, and in which the recess (10) is provided with a tight fit around the semiconductor chip (5) and the contact pads are connected <u>via</u> wire connections (7) to conductor tracks (11) on the substrate foil (4),
<u>characterized in that</u>
for each semiconductor chip (5)
a) the foil constituting the carrier member (4) supports at the side connected to the wire connections (7) an annular bounding member (8) at such a height that the spacing between the lower side of the carrier member (4) and the upper edge of the bounding member is substantially equal to the thickness of the card body (3) and the unit (4, 5, 8) thus formed is inserted into a recessed portion (14) of the card body (3),
b) the space within the bounding member (8) up to the surface area bounded by its upper edge is filled with a covering mass (9) enclosing the semiconductor chip (5) and the connecting wires (7).

2. A data card as claimed in Claim 1, characterized in that, at least that portion of the lower surface of the carrier member (4) constituted by the recess (10) is covered with an auxiliary foil (6) carrying the semiconductor chip (5).

3. A data card as claimed in one of the preceding Claims, characterized in that, the upper covering foil (1) is provided over at least one of the semiconductor chips (5) with a radiation-permeable window.

4. A data card as claimed in any one of the preceding Claims, characterized in that, the carrier member (4) consists of glass epoxy or PVC.

5. A data card as claimed in any one of the preceding Claims, characterized in that, the bounding member (8) consists of glass epoxy or PVC.

6. A data card as claimed in any one of the preceding Claims, characterized in that, the covering mass (9) consists of epoxy resin or silicon rubber.

7. A method of producing a data card as claimed in Claim 1 or 2, characterized in that, the lower side of the carrier member (4) is first covered with a foil (6), the semiconductor chip (5) is thereafter cemented to the foil in the punched out portion of the carrier member, the wire connections (7) between the semiconductor chip (5) and the conductor tracks (11) on the carrier member (4) are produced, the bounding member is provided and the interior space of this bounding member is filled with the covering mass (9) and then, before completion of the card, the foil (6) is again removed from the bottom surfaces of the carrier member (4).

8. A method as claimed in Claim 7, characterized in that, a self-adhering foil is used.

## Revendications

1. Carte d'information comportant une âme de carte (3) disposée entre une pellicule de parement inférieure (2) et une pellicule de parement supérieure (1), dans laquelle, à l'endroit d'une partie de l'âme de carte, est présent au moins un substrat pour au moins un composant semi-conducteur, chaque composant semi-conducteur étant formé par une puce semi-conductrice (5), qui est disposée dans un évidement d'une plaquette formant le substrat (4) est connectée électriquement à des pistes conductrices (11) prévues sur cette plaquette et est encapsulée au moyen d'une résine pour former une unité compacte d'épaisseur prédéfinie avec la plaquette, et dans laquelle l'évidement (10) encercle la puce semi-conductrice (5) de manière étroite et les surfaces de mise en contact sont connectées par des fils de connexion (7) à des pistes conductrices (11) présentes sur le substrat (4),

   caractérisée en ce que
   pour chaque puce semi-conductrice (5):

   a) la plaquette formant le substrat (4) porte, sur le côté connecté aux fils de connexion (7), un corps de délimitation annulaire (8) entourant la puce semi-conductrice et les points de connexion, d'une hauteur telle que la distance séparant la face inférieure du substrat (4) du bord supérieur du corps de délimitation soit pratiquement égale à l'épaisseur de l'âme de carte (3), et l'unité ainsi formée est insérée dans un évidement (14) de l'âme de carte (3), et

   b) l'espace existant à l'intérieur du corps de délimitation (8) est rempli jusqu'à la surface limitée par son bord supérieur d'une matière d'encapsulation (9) enrobant la puce semi-conductrice (5) et les fils de connexion (7).

2. Carte d'information suivant la revendication 1, caractérisée en ce qu'au moins la partie de la surface inférieure du substrat (4) formée par l'évidement (10) est couverte par une pellicule auxiliaire (6) portant la puce semi-conductrice (5).

3. Carte d'information suivant l'une quelconque des revendications précédentes, caractérisée en ce que la pellicule de parement supérieure (1) est pourvue, sur au moins une des puces semiconductrices (5), d'une fenêtre laissant passer un rayonnement.

4. Carte d'information suivant l'une quelconque des revendications précédentes, caractérisée en ce que le substrat (4) est en verre-époxy ou en PVC.

5. Carte d'information suivant l'une quelconque des revendications précédentes, caractérisée en ce que le corps de délimitation (8) est en verre-époxy ou en PVC.

6. Carte d'information suivant l'une quelconque des revendications précédentes, caractérisée en ce que la matière d'encapsulation (9) est formée de résine époxyde ou de caoutchouc de silicone.

7. Procédé de fabrication d'une carte d'information suivant la revendication 1 ou 2, caractérisé en ce que le substrat (4) est d'abord recouvert d'une pellicule (6) sur sa face inférieure, puis la puce semi-conductrice (5) est collée sur la pellicule dans l'évidement (10) du substrat, les fils de connexion (7) sont mis en place entre la puce semi-conductrice (5) et les pistes conductrices (11) présentes sur le substrat (4), le corps de délimitation (8) est mis en place et le volume intérieur libre de ce corps de délimitation est rempli au moyen de la matière d'encapsulation (9), après quoi, avant l'achèvement de la carte, la pellicule (6) est retirée de la surface inférieure du substrat (4).

8. Procédé suivant la revendication 7, caractérisé en ce qu'une pellicule autoadhésive est utilisée.

Fig.1

Fig.2